# DEMANDE DE BREVET EUROPEEN

(11) **EP 0 984 466 A2**
(43) Date de publication de la demande: **08.03.2000**
(21) Numéro de dépôt: 99117310.5
(22) Date de dépôt: 03.09.1999
(51) Int. Cl.: H01G 4/00, H01L 29/92

(54) **Capacité intégrée à forte linéarité en tension et faible résistance série**

(30) Priorité: 04.09.1998 FR 9811221
(71) Demandeur: STMicroelectronics S.A., 94250 Gentilly (FR); FRANCE TELECOM, 75015 Paris (FR)
(72) Inventeur: Delpech, Philippe, 83000 Toulon (FR); Robilliart, Etienne, 83000 Toulon (FR); Dutartre, Didier, 83000 Toulon (FR)
(74) Mandataire: Ballot, Paul Denis Jacques

(57) **Abrégé**

L'invention concerne une capacité (C₁) intégrée sur un substrat de silicium (7), comprenant une première électrode (1) en polysilicium fortement dopée, une couche mince (3) d'oxyde de silicium, une deuxième électrode (10) en polysilicium et une couche de siliciure (4) recouvrant la deuxième électrode. Selon l'invention, la deuxième électrode (10) présente une forte concentration en dopant à son interface avec l'oxyde de silicium (3) et une concentration en dopant faible ou moyenne à son interface avec le siliciure (4).

## Description

La présente invention concerne le domaine des circuits intégrés et plus particulièrement celui des capacités intégrées sur substrat de silicium.

A l'heure actuelle, il est de pratique courante de réaliser des circuits intégrés pourvus d'une ou plusieurs capacités intégrées de forte valeur, remplaçant avantageusement les condensateurs conventionnels se présentant sous forme de composants discrets. De telles capacités trouvent diverses applications dans le domaine des circuits analogiques ou radio fréquence, par exemple pour le filtrage des tensions d'alimentation, la réalisation de circuits d'antenne résonants de type LC,...

Parmi les capacités intégrées connues, les capacités du type polysilicium/oxyde/polysilicium offrent divers avantages comme une faible résistance série, une valeur élevée par unité de surface, une faible variation en fonction de la température et, sous certaines conditions, une bonne linéarité en fonction de la tension, c'est-à-dire une valeur sensiblement constante quelle que soit la tension appliquée.

Dans la présente, le terme polysilicium désigne du silicium polycristallin.

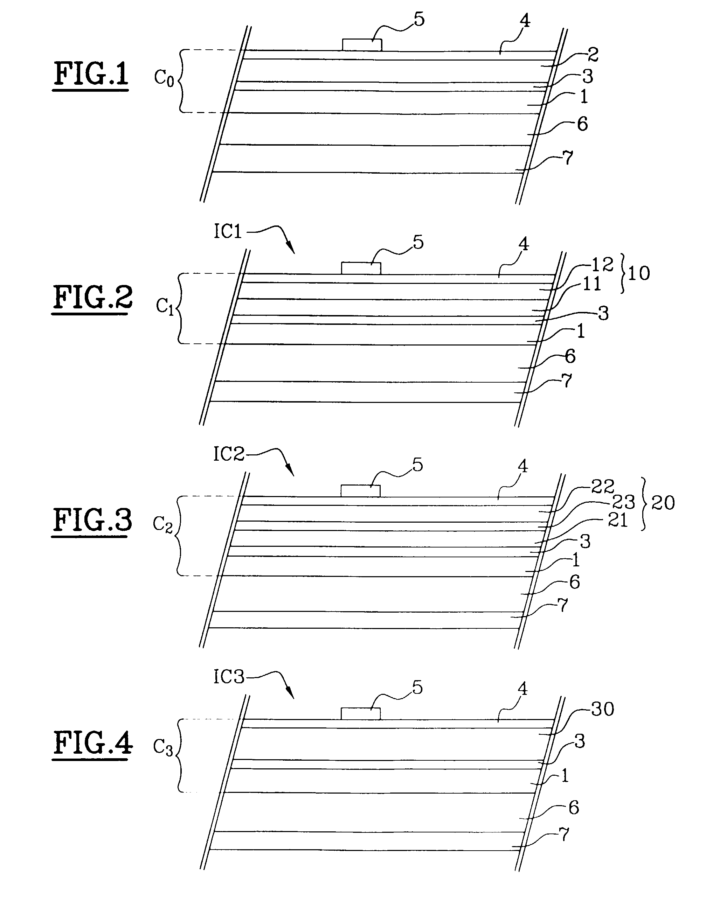

La figure 1 est une vue partielle en coupe d'une capacité C₀ du type susmentionné, intégrée dans une puce de silicium. La capacité comprend des électrodes 1, 2 en polysilicium séparées par une couche mince 3 d'oxyde de silicium. L'électrode supérieure 2 est recouverte d'une couche de siliciure 4, en général un siliciure métallique comme du siliciure de titane TiSi2. L'électrode supérieure 2 est par ailleurs pourvue d'un moyen de contact électrique 5, par exemple une plage métallisée ou une piste conductrice. La capacité C₀ est réalisée sur une couche épaisse d'oxyde de silicium 6 déposée sur un substrat de silicium 7. La couche mince d'oxyde 3 est de faible épaisseur, typiquement 30 nanomètres et les électrodes 1, 2 sont d'une épaisseur de l'ordre de 200 à 300 nanomètres. Enfin, les électrodes 1, 2 sont dopées à l'arsenic ou au phosphore et présentent ainsi un dopage de type N.

Comme cela est bien connu de l'homme de l'art, le polysilicium, même fortement dopé, présente une conductivité électrique médiocre. La couche de siliciure métallique 4 présente par contre une bonne conductivité et permet de pallier cet inconvénient. Ainsi, en l'absence d'un traitement par siliciuration, une capacité intégrée polysilicium/oxyde/polysilicium présente une forte résistance série qui s'avère gênante en fonctionnement alternatif, notamment dans un circuit résonant LC dont elle modifie le facteur de qualité.

Par ailleurs, il est connu que l'obtention d'une capacité ayant une bonne linéarité en tension nécessite un fort dopage des électrodes, permettant de limiter l'apparition dans le polysilicium d'une zone de déplétion s'opposant au passage du courant.

Ainsi, une capacité intégrée idéale comprend des électrodes de polysilicium fortement dopées et une couche de siliciure sur son électrode supérieure. Une telle capacité offre une bonne linéarité en tension et une faible résistance série.

En pratique, la réalisation d'une telle capacité se heurte toutefois au fait que le surdopage de l'électrode supérieure est incompatible avec le processus de siliciuration de l'électrode, à température modérée en présence d'un métal, le dopant ralentissant la diffusion du silicium dans le métal et pouvant même bloquer l'ensemble du processus. Ainsi, il est fréquent qu'une couche de polysilicium fortement dopée présente après siliciuration des zones entièrement dépourvues de siliciure. De plus, on s'est aperçu que la concentration en dopant dans l'électrode supérieure diminue sensiblement au cours du processus de siliciuration, par migration du dopant dans la couche de siliciure en formation.

Ces divers phénomènes font que l'on se satisfait en pratique d'un compromis consistant à réaliser une capacité ayant une électrode supérieure moyennement dopée se prêtant bien au processus de siliciuration mais offrant une linéarité en tension qui n'est pas optimale.

La présente invention vise à pallier cet inconvénient.

Plus particulièrement, la présente invention a pour objectif de prévoir une capacité offrant à la fois une linéarité en tension optimale et une résistance série minimale.

Succintement, pour atteindre ces objectifs, l'invention prévoit de rendre indépendantes les concentrations superficielles de dopant de l'électrode en polysilicium, la concentration de dopant à l'interface avec le diélectrique en oxyde de silicium étant distincte de la concentration de dopant à la surface destinée à être siliciurée.

L'invention est réalisée avec une capacité intégrée sur un substrat de silicium, comprenant une première électrode en polysilicium fortement dopée, une couche mince d'oxyde de silicium, une deuxième électrode en polysilicium et une couche de siliciure recouvrant la deuxième électrode, caractérisée en ce que la deuxième électrode présente une forte concentration en dopant à son interface avec l'oxyde de silicium et une concentration en dopant faible ou moyenne à son interface avec le siliciure.

Selon un premier mode de réalisation de capacité selon l'invention, la deuxième électrode comprend au moins deux couches de polysilicium ne présentant pas la même concentration en dopant.

Selon l'invention, la deuxième électrode comprend une première couche de polysilicium fortement dopée, agencée du côté de l'oxyde, et une deuxième couche de polysilicium faiblement ou moyennement dopée.

De préférence la première couche de polysilicium présente une concentration en dopant de l'ordre de 4 à 8 10²⁰ atomes par cm³ et la deuxième couche de polysilicium une concentration en dopant de l'ordre de 1 à 2 10²⁰ atomes par cm³.

Selon un deuxième mode de réalisation de capacité selon l'invention, les deux couches de polysilicium sont séparées par une couche mince métallique.

Selon une alternative, la couche mince métallique est formée d'un métal choisi parmi le groupe comprenant le Titane, le Tungstène, le Cobalt, le Tantale.

Selon une autre alternative, la couche mince métallique comprend deux couches minces de deux métaux ou alliages différents.

De préférence, la couche mince métallique comprend une couche de Titane et une couche de Nitrure de Titane.

Selon un troisième mode de réalisation de capacité selon l'invention, la deuxième électrode comprend une couche de polysilicium ayant un profil de concentration en dopant décroissant en allant de son interface avec l'oxyde de silicium vers son interface avec le siliciure.

De préférence, la concentration en dopant de la deuxième électrode est de l'ordre de 4 à 8 10²⁰ atomes par cm³ du côté de l'oxyde et de l'ordre de 1 à 2 10²⁰ atomes par cm³ du coté de la couche de siliciure.

Lors de la réalisation d'une capacité selon l'invention, il est prévu de préférence que le siliciure recouvrant la deuxième électrode est formé à partir d'un métal choisi parmi le groupe comprenant le Titane, le Tungstène, le Cobalt, le Tantale.

Enfin, il est prévu une réalisation de circuit intégré ayant la particularité de comprendre au moins une capacité selon l'invention.

Ces caractéristiques de la présente invention seront exposées plus en détail dans la description suivante de trois modes de réalisation de capacité selon l'invention, en relation avec les figures jointes parmi lesquelles :
- la figure 1 précédemment décrite est une vue en coupe d'une capacité intégrée classique,
- la figure 2 est une vue en coupe d'un premier mode de réalisation d'une capacité intégrée selon l'invention,
- la figure 3 est une vue en coupe d'un second mode de réalisation d'une capacité intégrée selon l'invention, et
- la figure 4 est une vue en coupe d'un troisième mode de réalisation d'une capacité intégrée selon l'invention.

Les figures 2, 3 et 4 représentent trois capacités C₁, C₂, C₃ selon l'invention. Comme la capacité C₀ décrite au préambule, les capacités C₁ à C₃ comprennent une électrode inférieure 1 en polysilicium fortement dopé, une couche mince d'oxyde 3, une couche de siliciure 4 et un moyen de contact 5, et sont réalisées sur une couche épaisse d'oxyde 6 déposée sur un substrat de silicium 7. Dans un souci de simplicité, les références de ces divers éléments ont été conservées.

Les capacités C₁ à C₃ se distinguent de la capacité C₀ par le fait qu'elle comprennent chacune une électrode supérieure, respectivement 10, 20, 30 présentant une concentration en dopant moyenne ou faible à l'interface avec la couche de siliciure 4, et une forte concentration en dopant à l'interface avec l'oxyde de silicium 3. Ainsi, ces capacités se prêtent bien au processus de siliciuration de leur électrode supérieure 10, 20, 30 tout en offrant une bonne linéarité en tension par la réduction de la zone de déplétion du polysilicium du côté de l'oxyde 3.

Plus particulièrement, sur la figure 2, l'électrode 10 de la capacité C₁ comprend une couche inférieure de polysilicium 11 fortement dopée et une couche supérieure de polysilicium 12 faiblement ou moyennement dopée. Par exemple, la couche 11 présente une concentration en dopant de l'ordre de 1 à 2 10²⁰ atomes par cm³ et la couche 12 une concentration de l'ordre de 4 à 8 10²⁰ atomes par cm³. Le dopant est classiquement de l'arsenic ou du phosphore. Chaque couche 11, 12 présente une épaisseur de l'ordre de la centaine de nanomètres, pour former une électrode 10 d'épaisseur classique.

Sur la figure 3, l'électrode 20 de la capacité C₂ comprend deux couches de polysilicium 21, 22 séparées par une couche mince métallique 23, les couches 21, 22 étant identiques aux couches 11, 12 de la capacité C₁. La couche mince métallique 23, d'une épaisseur de quelques dizaines de nanomètres, par exemple 20 nanomètres, comprend un métal ou un alliage compatible avec le polysilicium, par exemple du Titane Ti, du Tungstène W, du Cobalt Co ou du Tantale Ta. Selon une variante, la couche mince 23 comprend deux couches minces de métaux et/ou d'alliages, par exemple une couche de Titane Ti et une couche de nitrure de Titane TiN.

Enfin, sur la figure 4, la capacité C₃ comprend une électrode monocouche 30 présentant un gradient de concentration en dopant, allant par exemple de 1 à 2 10²⁰ atomes par cm³ du côté de la couche de siliciure 4 pour atteindre la valeur de 4 à 8 10²⁰ atomes par cm³ du côté de la couche d'oxyde 3.

Les tableaux 1, 2, 3 ci-après décrivent les procédés de fabrication respectifs des capacités C₁, C₂, C₃. De façon classique, les diverses couches de polysilicium sont déposées par CVD ("Chemical Vapor Deposition", ou dépôt en phase vapeur) dans un four basse pression, à une température de l'ordre de 600°C et en présence d'un composé du silicium comme le silane. La siliciuration des électrodes 10 (couche 12), 20 (couche 22) ou 30 est réalisée en présence d'un métal comme du titane Ti, du Cobalt Co, du Tungstène W, du Tantale Ta..., et comprend une étape de dépôt du métal et une étape de recuit à température modérée, par exemple à 700°C pendant 30 secondes. L'étape TA de recuit pour la redistribution des dopants est faite par exemple à 1050°C pendant 30 mn. L'étape de recuit flash RTA ("Rapid Thermal Annealing") pour l'activation des dopants, est faite par exemple à 1050 °C pendant 20 secondes.

**Tableau 1 :**

| **réalisation de la capacité C**_{**1**} **(fig. 2)** |
|---|
| DP₁-Dépôt de la première électrode en polysilicium 1 |
| II₁-Implantation ionique à forte dose d'arsenic ou de phosphore |
| DO-Dépôt de la couche d'oxyde 3 |
| DP₂-Dépôt de la première couche 11 de la deuxième électrode 10 e polysilicium |
| II₂-Implantation ionique à forte dose d'arsenic ou de phosphore |
| TA-Recuit pour la redistribution des dopants implantés |
| DP₃-Dépôt de la deuxième couche 12 de la deuxième électrode 10 e polysilicium |
| II₃-Implantation ionique à dose modérée d'arsenic ou de phosphore |
| SI-Siliciuration de la couche de polysilicium 12 |
| RTA-Recuit flash pour l'activation des dopants |

**Tableau 2 :**

| **réalisation de la capacité C**_{**2**} **(fig. 3)** |
|---|
| DP₁-Dépôt de la première électrode de polysilicium 1 |
| II₁-Implantation ionique à forte dose d'arsenic ou de phosphore |
| DO-Dépôt de la couche d'oxyde 3 |
| DP₂-Dépôt de la première couche 21 de la deuxième électrode 20 e polysilicium |
| II₂-Implantation ionique à forte dose d'arsenic ou de phosphore |
| DP₁-Dépôt de la première électrode en polysilicium 1 |
| DP₃-Dépôt de la deuxième couche 22 de la deuxième électrode 20 e polysilicium |
| II₃-Implantation ionique à dose modérée d'arsenic ou de phosphore |
| TA-Recuit pour la redistribution des dopants implantés |
| SI-Siliciuration de la couche de polysilicium 22 |
| 1.RTA-Recuit flash pour l'activation des dopants |

**Tableau 3 :**

| **réalisation de la capacité C**_{**3**} **(fig. 4)** |
|---|
| II₁-Implantation ionique à forte dose d'arsenic ou de phosphore |
| DO-Dépôt de la couche d'oxyde 3 |
| TA-Recuit pour la redistribution des dopants implantés |
| DDP₂-Dépôt de la deuxième électrode 30 en polysilicium, avec dopage in situ à concentration décroissante |
| SI-Siliciuration de la deuxième électrode 30 |
| RTA-Recuit flash pour l'activation des dopants |

Dans le premier procédé (tableau 1), l'étape de recuit thermique TA est effectuée après le dépôt de la première électrode 1 et de la première couche 11 de la deuxième électrode 10. Le recuit thermique est minimisé après le dépôt de la deuxième couche 12 afin d'empêcher la migration des dopants de la couche 11 vers la couche 12, qui est la moins dopée. Seule l'étape de recuit flash RTA est réalisée, afin d'activer les dopants. Le recuit RTA, de courte durée, et l'étape de siliciuration SI à température modérée ne sont pas susceptibles d'entraîner une redistribution sensible des dopants entre les couches 11 et 12.

Dans le second procédé (tableau 2), l'étape de recuit TA est effectuée après dépôt des trois couches de polysilicium, la couche mince métallique 23 formant une barrière à la diffusion de dopants entre les couches 21 et 22.

Dans le troisième procédé (tableau 3), l'étape de recuit TA est réalisée après dépôt et implantation ionique de la première électrode 1. Il n'y a pas d'étape de recuit pour la redistribution des dopants appliquée à la deuxième électrode 30, qui est dopée in situ. Le dépôt et le dopage de l'électrode 30 sont réalisés simultanément, la croissance du polysilicium étant faite en présence d'un composé dopant comme de l'arsine ou de la phosphine, en diminuant progressivement la pression partielle du gaz dopant, pour l'obtention d'une concentration en dopant décroissante. Comme précédemment, le recuit RTA et l'étape de siliciuration SI ne sont pas susceptibles d'entraîner une redistribution sensible des dopants à l'intérieur de l'électrode 30.

Comme cela apparaîtra clairement à l'homme de l'art, le choix de l'une ou de l'autre des structures d'électrodes 10, 20, 30 selon l'invention dépend du procédé de fabrication du circuit intégré dans lequel la capacité est agencée, et plus particulièrement de l'instant où est réalisée l'étape de recuit TA pour la redistribution des dopants. En effet, il est bien évident que les figures 2 à 4 ne sont que des vues partielles de circuits intégrés, respectivement IC₁, IC₂, IC₃, comportant divers autres composants électroniques comme des transistors, des diodes, des résistances, ... Les étapes de recuit TA permettent de redistribuer les dopants dans les électrodes de la capacité mais également dans toutes les couches de silicium ou de polysilicium du circuit intégré. Ainsi, le procédé de fabrication de la capacité est indissociable en pratique du procédé de fabrication collective des autres éléments du circuit intégré.

De façon générale, il ressort de ce qui précède que la capacité C₂ (figure 3) convient à tous types de procédés de fabrication, notamment les procédés nécessitant que l'étape de recuit TA soit effectuée après la réalisation de l'électrode supérieure. Les capacités C₁ et C₃ présentent l'avantage d'être plus simples à réaliser mais nécessitent que le procédé de fabrication du circuit intégré ne comporte pas, après la réalisation de la deuxième électrode 10 ou 20, une étape de recuit ou un cycle thermique susceptible d'entraîner une redistribution de dopants.

En définitive, l'homme de l'art souhaitant réaliser une capacité selon l'invention choisira l'une des trois structures proposées plus haut en fonction du processus de fabrication envisagé pour l'ensemble du circuit intégré, ou adaptera le processus de fabrication à la structure de capacité qu'il souhaite réaliser. D'après la demanderesse, l'évolution des procédés de fabrication va dans le sens d'une minimisation des étapes de recuit et l'on peut estimer que des capacités du type C₁ ou C₂ pourront être prévues à l'avenir dans un nombre croissant de circuits intégrés.

## Revendications

1. Capacité (C₁, C₂, C₃) intégrée sur un substrat de silicium (7), comprenant une première électrode (1) en polysilicium fortement dopée, une couche mince (3) d'oxyde de silicium, une deuxième électrode (10, 20, 30) en polysilicium et une couche de siliciure (4) recouvrant la deuxième électrode, caractérisée en ce que la deuxième électrode (10, 20, 30) présente une forte concentration en dopant à son interface avec l'oxyde de silicium (3) et une concentration en dopant faible ou moyenne à son interface avec le siliciure (4).

2. Capacité (C₁) selon la revendication 1, caractérisée en ce que la deuxième électrode (30) comprend une couche de polysilicium ayant un profil de concentration en dopant décroissant en allant de son interface avec l'oxyde de silicium (3) vers son interface avec le siliciure (4).

3. Capacité selon la revendication 2, dans laquelle la concentration en dopant de la deuxième électrode (30) est de l'ordre de 4 à 8 10²⁰ atomes par cm³ du côté de l'oxyde (3) et de l'ordre de 1 à 2 10²⁰ atomes par cm³ du coté de la couche de siliciure (4).

4. Capacité (C₂, C₃) selon la revendication 1, caractérisée en ce que la deuxième électrode (10, 20) comprend au moins deux couches (11, 12, 21, 22) de polysilicium ne présentant pas la même concentration en dopant.

5. Capacité selon la revendication 4, dans laquelle la deuxième électrode comprend une première couche (11, 21) de polysilicium fortement dopée, agencée du côté de l'oxyde, et une deuxième couche (12, 22) de polysilicium faiblement ou moyennement dopée.

6. Capacité selon la revendication 5, dans laquelle la première couche de polysilicium (11, 21) présente une concentration en dopant de l'ordre de 4 à 8 10²⁰ atomes par cm³ et la deuxième couche de polysilicium (12, 22) une concentration en dopant de l'ordre de 1 à 2 10²⁰ atomes par cm³.

7. Capacité (C₃) selon l'une des revendications 4 à 6, caractérisée en ce que les deux couches de polysilicium (21, 22) sont séparées par une couche mince métallique (23).

8. Capacité selon la revendication 7, dans laquelle la couche mince métallique (23) est formée d'un métal choisi parmi le groupe comprenant le Titane, le Tungstène, le Cobalt, le Tantale.

9. Capacité selon la revendication 7, dans laquelle la couche mince métallique (23) comprend deux couches minces de deux métaux ou alliages différents.

10. Capacité selon la revendication 9, dans laquelle la couche mince métallique (23) comprend une couche de Titane et une couche de Nitrure de Titane.

11. Capacité (C₁, C₂, C₃) selon l'une des revendications 1 à 10, dans laquelle le siliciure recouvrant la deuxième électrode est formé à partir d'un métal choisi parmi le groupe comprenant le Titane, le Tungstène, le Cobalt, le Tantale.

12. Circuit intégré (IC₁, IC₂, IC₃), caractérisé en ce qu'il comprend au moins une capacité (C₁, C₂, C₃) selon l'une des revendications précédentes.
